# EUROPÄISCHE PATENTSCHRIFT

(11) **EP 1 680 800 B1**
(45) Veröffentlichungstag und Bekanntmachung des Hinweises auf die Patenterteilung: **02.12.2009**
(21) Anmeldenummer: 04802669.4
(22) Anmeldetag: 29.10.2004
(51) Int. Cl.: H01J 37/305

(54) **VERFAHREN UND VORRICHTUNG ZUR IONENSTRAHLBEARBEITUNG VON OBERFLÄCHEN**
METHOD AND DEVICE FOR ION BEAM PROCESSING OF SURFACES
PROCEDE ET DISPOSITIF DE TRAITEMENT DE SURFACES PAR FAISCEAU IONIQUE

(30) Priorität: 31.10.2003 DE 10351059
(43) Veröffentlichungstag der Anmeldung: 19.07.2006
(73) Patentinhaber: Roth & Rau AG, 09337 Hohenstein-Ernstthal (DE)
(72) Erfinder: MAI, Joachim, 04603 Nobitz (DE); ROTH, Dietmar, 09353 Oberlungwitz (DE); RAU, Bernd, 08451 Crimmitschau (DE); DITTRICH, Karl-Heinz, 09125 Chemnitz (DE)
(74) Vertreter: Pätzelt, Peter
(86) Internationale Anmeldenummer: PCT/DE2004/002436
(87) Internationale Veröffentlichungsnummer: WO 2005/042141

(56) Entgegenhaltungen:
- EP-A- 0 579 524
- EP-A- 1 253 619
- DE-A1- 19 814 760
- US-A- 3 699 334

## Beschreibung

### Technisches Gebiet

Die Erfindung betrifft ein Verfahren zur Ionenstrahlbearbeitung der Oberfläche eines Substrates, bei dem das Substrat gegenüber einem Ionenstrahl, der von einer Ionenstrahlquelle erzeugt wird, positioniert wird, und das bekannte Eigenschaftsmuster der Oberfläche des Substrates durch den Ionenstrahl mit einem definierten Wirkungsmuster partiell derart bearbeitet wird, dass ein neues technologisch definiertes Eigenschaftsmuster der Oberfläche ausgebildet wird. Weiterhin betrifft die Erfindung eine Vorrichtung zur Durchführung des Verfahrens nach Anspruch 5.

Dabei werden unter Eigenschaftsmuster der Oberfläche eines Substrates alle die auf definierte Flächenbereiche der Oberfläche eines Substrates bezogenen physikalischen und chemischen Eigenschaften sowie die Oberflächentopogräfie verstanden. Das Wirkungsmuster des Ionenstrahls beinhaltet die auf definierte Flächenbereiche des Substrates, auf denen die Ionen eines Ionenstrahls einwirken, bezogenen örtlichen Ionenstromdichteverteilungen mit entsprechender Ionenenergieverteilung.

### Stand der Technik

Nach dem Stand der Technik sind Verfahren und Einrichtungen bekannt, bei denen ein Ionenstrahl mit konstanter Strahlcharakteristik mit variabler Geschwindigkeit gegenüber der zu bearbeitenden Oberfläche eines Substrates bewegt wird. Mit der Strahlcharakteristik wird die Ionenbeschleunigung, die Ionenenergieverteilung, die Ionenstromdichte und die Ionendichteverteilung des Ionenstrahls Ionenstrahlquelle beschrieben. Auch der Einsatz von Blenden zwischen der Ionenstrahlquelle und dem Substrat ist bekannt.

Besonders für die Mikro- und Nanotechnologien in verschiedenen Branchen ist die Bearbeitung der Oberflächentopographie eines Substrates von entscheidender Bedeutung. Sowohl die Fertigung gezielt einstellbarer Schichtdicken durch das Abdünnen von Schichten in der Dünnschichttechnologie, bis hin zum gezielten Abtrag einzelner Atomlagen, als auch die Nano-Profilierung von "high-grade" Oberflächen erfordern dafür zunehmend den Einsatz von Ionenstrahlen als Arbeitswerkzeug.

Neben der geometrischen Änderung der Oberflächentopographie im Sinne von Abtragen oder Beschichten ist für die Mikro- und Nanotechnologien auch die lokale Änderung der Eigenschaften der Oberfläche von Bedeutung. So ist bekannt, dass bei ionenstrahlgestützten Abscheidungsverfahren durch das gleichzeitige Auftreffen von Ionen während der Beschichtung auf dem Substrat die Eigenschaften der abgeschiedenen Schicht beeinflusst werden. Damit kann z.B. die Dichte der abgeschiedenen Schicht variiert werden oder das Wachstum der Schicht von amorph zu kristallin geändert oder auch die Stöchiometrie der Schicht beeinflusst werden.

Auch die gezielte Modifikation von Oberflächen ist durch den Ionenbeschuss der Oberfläche möglich. Hier sollen nur das Aufbrechen von funktionellen Gruppen an der Oberfläche von Plastikmaterialien, z.B. zur Veränderung von Hafteigenschaften, und das Einbringen von Fremdatomen, z.B. zur Oberflächenhärtung, genannt werden.

Nach dem Stand der Technik gibt beispielsweise die US 3,699,334 A ein Verfahren zur Anwendung eines Ionenstrahls für die kontrollierte Erosion einer Oberfläche an. Der fokussierte Ionenstrahl weist ein Beschleunigungspotential bis 120.000 Volt und einen konstanten Elektronenstrom auf. Allgemein hat der Ionenstrahl einen Durchmesser zwischen 1 und 5 mm, wobei ein Ionenstrahl mit 30 µ-Ampere und 1 mm² Durchmesser eine Stromdichte von ca. 40 µ-Ampere/mm² und ein Ionenstrahl mit 500 µ-Ampere und 5 mm² Durchmesser eine Stromdichte von ca. 25 µ-Ampere/mm² aufweist. Der Ionenstrahl wird in Kombination von kontrollierter Erosionsrate und in der Richtung kontrolliert auf die Oberfläche des bewegten Werkstückes gerichtet. Die Bewegung von Ionenstrahl und Werkstück kann in programmierten automatischen Abläufen erfolgen. Höhere Erosionsraten werden mit geringere und niedrigere Erosionsraten werden mit höherer Bewegungsgeschwindigkeit des Werkstückes erreicht.

Die DE 198 14 760 A1 beschreibt z.B. ein Verfahren zur Ionenstrahlbearbeitung von Festkörperoberflächen bei rechteckigem Strahlquerschnitt. Dabei wird die Ionenstrahlquelle unter einen in der Werkstückoberfläche liegenden vorzugebenden Anfangswinkel mit translatorischer unter Geschwindigkeitsvariation in Abhängigkeit von der Position, Ionenstrahlparameter und Materialeigenschaften in einem bestimmten festen oder variablen Abstand rechnergesteuert über das Werkstück gesteuert.

Dokument EP 1253619A beschreibt einen Belichtungsapparat zur Lithographie mit Elektronen oder Ionen, mit einer Vielzahl von Einzelstrahlen, die individuell abblendbar ("blanking"), fokussierbar und ablenkbar sind.

### Darstellung der Erfindung

Der Erfindung liegt die Aufgabe zugrunde, ein Verfahren zur Ionenstrahlbearbeitung von Oberflächen der eingangs genannten Art anzugeben, mit dem eine hohe Effektivität erreicht wird und der technische Aufwand gering ist. Weiterhin besteht die Aufgabe eine Einrichtung zur Durchführung des Verfahrens anzugeben.

Die Erfindung löst die Aufgabe für das Verfahren durch die im Anspruch 1 angegebenen Merkmale. Für die Einrichtung wird die Aufgabe durch die im Anspruch 5 angegebenen Merkmale gelöst. Vorteilhafte Weiterbildungen der Erfindungen sind in den jeweiligen Unteransprüchen gekennzeichnet und werden nachstehend zusammen mit der Beschreibung der bevorzugten Ausführung der Erfindung, einschließlich der Zeichnung, näher dargestellt.

Der Kern der Erfindung besteht im neuartigen Einsatz des Ionenstrahls, indem die technologisch erforderliche Wirkung des Ionenstrahles auf der Oberfläche des Substrates mittels Veränderung der Strahlcharakteristik und/oder durch Pulsung des Ionenstrahles in Abhängigkeit des bekannten Eigenschaftsmusters der Oberfläche und des herzustellenden neuen technologisch definierten Eigenschaftsmusters der Oberfläche in Abhängigkeit des Verfahrensfortschrittes eingestellt wird. Dabei wird das aktuelle geometrische Wirkungsmuster des Ionenstrahls auf der Oberfläche des Substrates jeweils an das aktuell bekannte Eigenschaftsmuster der Oberfläche angepasst. Die Eigenschaftsänderung definierter Oberflächenbereiche durch den Ionenstrahl wird danach durch eine zeitlich gesteuerte Strahlcharakteristik bestimmt.

Erfindungsgemäß kann die Ionenstrahlquelle und damit der Ionenstrahl gegenüber der zu bearbeitenden Oberfläche eines Substrates fixiert sein oder in einer Weiterbildung entsprechend Anspruch 2 auch bewegt werden.

Geeignete Verfahren und Einrichtungen zum Erfassen des Eigenschaftsmusters der Oberfläche des Substrates und zur in-situ Erfassung des aktuellen Wirkungsmusters des Ionenstrahls zur Veränderung der Ionenstrahlcharakteristik während des Verfahrensablaufes sind nach dem Stand der Technik bekannt.

Insbesondere für die Bearbeitung größerer Substrate oder Substratanordnungen ist es vorteilhaft, entsprechend Anspruch 3 mindestens zwei Einzel-Ionenstrahlquellen kombiniert anzuordnen, derart dass die Einzel-Ionenstrahlen gemeinsam das geometrische Wirkungsmuster des erfindungsgemäßen Ionenstrahls ausbilden.

Der Ionenstrahl oder die Einzel-Ionenstrahlen können nach Anspruch 3 auch zeitgleich oder zeitlich versetzt gepulst werden. Dabei kann die Pulsfrequenz, Pulshöhe sowie die Pulsdauer entsprechend.den technischen Gegebenheiten frei programmiert werden.

Für spezifische Aufgaben kann entsprechend Anspruch 4 der Winkel zwischen der Flächennormalen der zu bearbeitenden Oberfläche des Substrates und der Achse des auf die Oberfläche auftreffenden Ionenstrahls auch verändert werden.

Für eine definierte reproduzierbare Ionenstrahlbearbeitung ist die Kenntnis der Strahlcharakteristik in Abhängigkeit von bestimmten Steuerparametern der Ionenstrahlquelle sowie die zeitliche Stabilität der Strahlcharakteristik entscheidend.

Zur Erfassung des Ionenstrahls auf der Oberfläche des Sustrates vor und/oder während des Verfahrensablaufes wird erfindungsgemäß, entsprechend Anspruch 1 in der Ebene der zu bearbeitenden Oberfläche des Substrates ein Ionensondenarray angeordnet, mit dem die geometrische Wirkung des Ionenstrahls gemessen wird.

Damit kann zu jeder Zeit die momentane Strahlcharakteristik bestimmt werden und in der Folge, wenn nötig, im erforderlichen Umfang korrigiert werden. Dabei ist auch eine automatische Regelung zur Korrektur der Strahlcharakteristik oder eine Nebenrechnung der Verfahrbedingungen des Substrates zur Erreichung des Zielmusters möglich.

Zur Durchführung der Ionenstrahlbearbeitung der Oberfläche eines Substrates nach einem der erfindungsgemäßen Verfahren, bei dem Substrat und Ionenstrahlquelle zueinander bewegt werden, wird eine Vorrichtung nach Anspruch 5 angegeben. Die Vorrichtung ist innerhalb einer Vakuumkammer angeordnet und beinhaltet einen Substratträger zur Halterung mindestens eines Substrates, der in einer Y-Achse und einer X-Achse bewegt werden kann. Die Ionenstrahlquelle ist in der Wand der Vakuumkammer derart gehaltert, dass die Achse eines Ionenstrahls von der Ionenstrahlquelle senkrecht zur zu bearbeitenden Oberfläche des Substrates in der Z-Achse steht oder in einem zur Z-Achse geneigten Achse angeordnet werden kann. Der Abstand der Ionenstrahlquelle von der zu bearbeitenden Oberfläche des Substrates kann fest oder veränderlich sein.

In einer Weiterbildung der Vorrichtung kann die Ionenstrahlquelle aus mindestens zwei einzelnen Ionenstrahlquellen bestehen, deren einzelne Ionenstrahlen auf der Oberfläche des Substrates ein gemeinsames aktuelles geometrisches Wirkungsmuster des Ionenstrahls ausbilden.

Mit dem erfindungsgemäßen Verfahren sowie der zugehörigen Vorrichtung können gegenüber dem Stand der Technik wesentliche Vorteile erzielt werden. Bei einer Vielzahl insbesondere kleinerer Substrate oder Substratanordnungen sind keinerlei aufwändige Bewegungseinrichtungen oder Blenden erforderlich. Ist technologisch bedingt eine Bewegung zwischen Substrat und Ionenstrahlquelle erforderlich, dann ist es meist ausreichend, eine gleichförmige Bewegung vorzusehen, die ebenfalls wesentlich einfacher realisiert werden kann als eine translatorische Bewegung unter Geschwindigkeitsvariation.

Die Anordnung von Substrat und Ionenstrahlquelle zueinander kann auch rasterförmig erfolgen. Das kann auch in Kombination mit einer Pulsung des Ionenstrahles sehr vorteilhaft sein, z.B. wenn eine Vielzahl von Substraten, im Durchlaufverfahren bearbeit werden soll.

Wird z.B. bei zeitlich stabiler Strahlcharakteristik der Ionenstrahl in einem zeitlich veränderlichen Zeitraster mittels elektrischer Steuerparameter zu- und abgeschaltet, so kann bei gleichzeitiger gleichförmiger Substratbewegung eine von der örtlichen effektiven Einwirkungsdauer des Ionenstrahls abhängige Oberflächenbearbeitung erreicht werden. Auch bei der zeitlich veränderlichen Strahlcharakteristik der Ionenstrahlquelle während der gleichförmigen Substratbewegung kann der Ionenstrahl in einem zeitlich veränderlichen Zeitraster z und abgeschaltet werden. Gleichzeitig zu der veränderlichen Strahlcharakteristik und der Pulsung der Steuergrößen der Ionenstrahlquelle ergibt sich die Möglichkeit der Ionenstrahlneutralisation. Dabei wird während der Sperrung des Ionenstrahls eine Elektronenextraktion durchgeführt.

Mit einer derartigen Verfahrensführung kann eine besonders flexible Ionenstrahlbearbeitung auch bei unterschiedlichen Substratmaterialien erreicht werden, z.B. wenn innerhalb der Substratoberfläche unterschiedliche Eigenschaftsbereiche mit stark abweichenden Abmessungen erzeugt werden sollen. Durch die zeitlich veränderliche Strahlcharakteristik kann die Genauigkeit der Bearbeitung und auch die Bearbeitungsgeschwindigkeit vorteilhaft an das zu erreichende örtliche Eigenschaftsmuster angepasst werden.

Die Erfindung wird nachstehend in einem Ausführungsbeispiel näher erläutert.

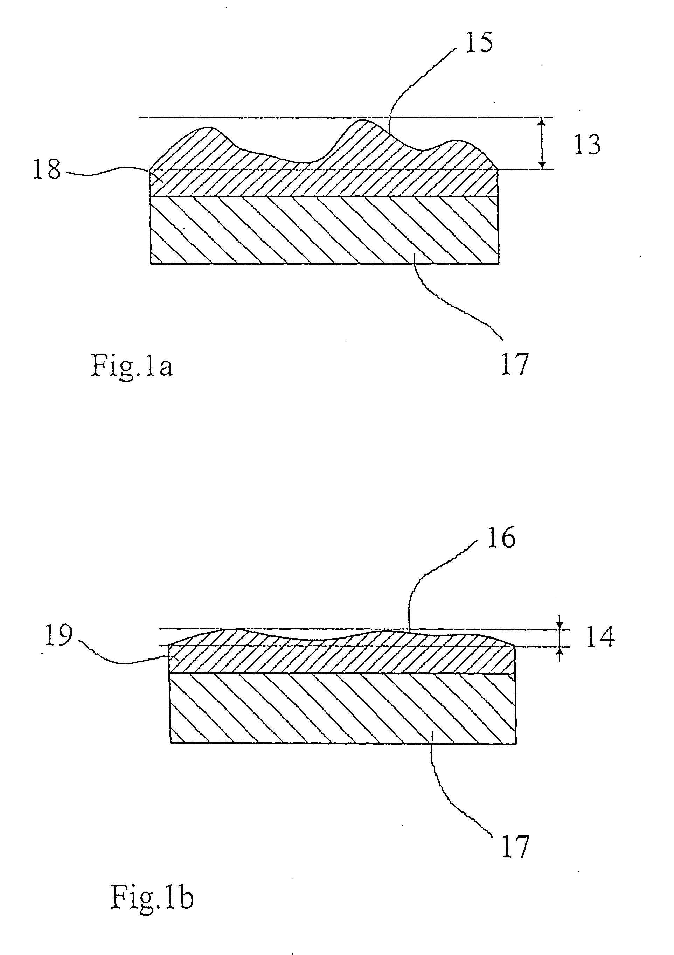

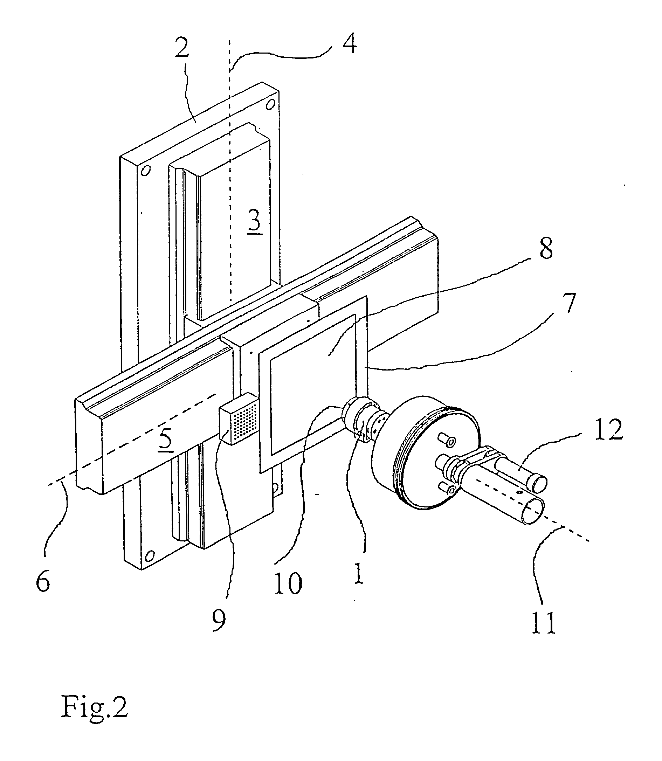

Die Zeichnung zeigt in den Figuren 1a und 1b ein Substrat mit einer Beschichtung, wobei Figur 1a die Beschichtung vor und Figur 2 nach einer Ionenstrahlbearbeitung zeigen. Figur 2 zeigt eine Vorrichtung zur Ionenstrahlbearbeitung des Substrates nach Figur 1a und 1b.

### Ausführungsbeispiel I

Ausgehend von einem Substrat 8, bestehend aus einem Grundkörper 17, auf dem eine Schicht 18 mit einer Oberfläche 15 entsprechend Figur 1a vorhanden ist, soll die Oberfläche 15 mit einem erfindungsgemäßen Verfahren und der erfindungsgemäßen Einrichtung nach Figur 2 derart bearbeitet werden, dass eine geglättete Oberfläche 16 der dann neuen Schicht 19 entsprechend Figur 1b erzeugt wird.

Die erfindungsgemäße Vorrichtung entsprechend Figur 2 besteht im Wesentlichen aus einem Substratträger innerhalb einer nicht dargestellten Vakuumkammer sowie einer Ionenstrahlquelle 1, die mittels eines Vakuumflansches in der Wand der Vakuumkammer gehaltert ist, derart dass die erforderlichen Steuerelemente sich weitgehend außerhalb der Vakuumkammer befinden.

Der Substratträger besteht aus einer Montageplatte 2, auf der eine Führungsschiene 3 mit einer Y-Achse 4 gehaltert ist, einer auf der Führungsschiene 3 in der Y-Achse 4 verschiebbaren Führungsschiene 5 mit einer X-Achse 6 sowie einem Substrathalter 7, der auf der X-Achse 6 verschoben und um seine eigene zentrische Achse (Z-Achse 11) gedreht werden kann. Auf dem Substrathalter 7 ist das Substrat 8 gehaltert.

In der Ebene des Substrates 8 ist am Substrathalter 7 ein Ionensondenarray 9 vorgesehen, welches aus 2 Spalten mit je 8 Ionensonden besteht und mit dem Substrathalter 7 bewegt wird. Das Ionensondenarray 9 ermöglicht ohne Unterbrechung des Vakuums eine schnelle und sichere Kontrolle und Vermessung der Strahlcharakteristik in Abhängigkeit von Steuerparametern der Ionenstrahlquelle 1.

Die Ionenstrahlquelle 1 besteht in bekannter Weise aus den erforderlichen elektrischen Elementen zur Erzeugung eines Ionenstrahls mit definierter geometrischer Strahlcharakteristik, der die Ionenstrahlquelle 1 an der Ionenaustrittsöffnung 10 verlässt. Zur Verschiebung der Ionenstrahlquelle 1 in der Z-Achse 11 weist die Z-Achse 11 außerhalb der Vakuumkammer einen Motor 12 mit entsprechendem Getriebe auf. Eine zugehörige Steuereinheit ist in der Zeichnung nicht dargestellt.

Mit der Vorrichtung nach Figur 2 kann das Substrat 8 gegenüber der Ionenstrahlquelle 1 in beliebiger Weise programmiert bewegt werden.

Alle wichtigen Gitterspannungen der Ionenstrahlquelle 1 können entsprechend den technischen Möglichkeiten auch gepulst werden. Dadurch ist sowohl eine vollständige zeitliche Sperrung des Ionenstrahls während der Ionenstrahlbearbeitung als auch eine zeitlich abgestimmte Variation möglich, wobei die Periodendauer als auch die Pulsdauer in einem weiten Bereich frei veränderbar sind.

Das Vakuumpumpsystem, die Gasversorgungen, einschließlich für reaktive Gase, sowie Vorrichtungen zur Temperierung bzw. Kühlung einzelner Baugruppen oder des Substrates 8 komplettieren die Vorrichtung.

Nachfolgend soll die Vorrichtung in der Anwendung näher beschrieben werden. Die Oberfläche 15 der Schicht 18 nach Figur 1a soll entsprechend vorgegebener technologischer Parameter eingeebnet werden, so dass die Oberfläche 16 auf der dann neuen Schicht 19 entsprechend Figur 1b ausgebildet wird.

Bei dem Grundkörper 17 des Substrates 8 handelt es sich im Beispiel um einen Siliziumwafer und als Schicht 18 ist eine Aluminiumschicht vorhanden. Der Durchmesser des Substrates 8 beträgt 150 mm. Die mittlere Schichtdickenhomogenität der aufgebrachten Aluminiumschicht beträgt ca. +/- 10% bei einer mittleren Schichtdicke von ca. 500 nm. Die ursprüngliche Rauigkeit 13 der Oberfläche (Figur 1a) soll auf eine definierte Rauigkeit 14 verringert werden (Figur 1b).

Das lokale Schichtdickenprofil wird dabei zunächst mittels einer Oberflächenwiderstandsmessung bestimmt und in einer Messmatrix abgelegt. Das Raster der Messmatrix beträgt dabei 2x2 mm.

Das Substrat 8 wurde definiert und gerichtet auf dem Substrathalter 7 befestigt, wodurch eine direkte Zuordnung eines jeden Messpunktes der Messmatrix zur X-Achse 6 und Y-Achse 4 (Koordinaten) gegeben ist.

Die Ionenaustrittsöffnung 10 der Ionenstrahlquelle 1 hat einen Durchmesser von 40 mm. Der Abstand zwischen Ionenaustrittsöffnung 10 und der Oberfläche 15 des Substrates 8 beträgt etwa 85 mm.

Nach der Evakuierung der Vakuumkammer und Erreichen der Betriebsbereitschaft der Ionenstrahlquelle 1 wird das Ionensondenarray 9 am Substrathalter 7 in den Ionenstrahl gefahren und die Strahlcharakteristik des Ionenstrahls gemessen und gegebenenfalls entsprechend dem technologischen Erfordernis nachgeregelt. Die Strahlcharakteristik wird dabei beispielsweise so eingestellt, dass bei einer Ionenenergie von ca. 800 eV eine Gauß-Verteilung der Ionenstromdichte mit einer Halbwertsbreite von 12 mm und ein Maximum der Ionenstromdichte von ca. 2.5 mA/cm² erreicht werden.

Mit Hilfe eines Berechnungsprogramms wird zur Erzeugung einer lokal erforderlichen Abtragsrate des Ionenstrahls auf der Oberfläche 15 eine Steuermatrix mit Werten der Pulsfrequenz zwischen 500 Hz bis 20kHz und des Pulslängenverhältnisses von 0,2 bis 0,98 in einer Steuereinheit abgelegt. Weiterhin werden für die Bearbeitungsgenauigkeit notwendige gleichförmige Verfahrgeschwindigkeiten und Zeilenabstände in die Steuermatrix eingetragen.

Während der Oberflächenbearbeitung wird nun über eine Zeitmatrix in Abhängigkeit der jeweiligen Verfahrgeschwindigkeit der Ionenstrahl vollständig gesperrt oder gepulst. Mit dieser Vorgehensweise wird im Verfahrensablauf eine Planarisierung der Oberfläche 16 (Figur 1b) mit einer Homogenität von kleiner +/-1% bei einer Bearbeitungszeit des Substrates 8 von ca. 10 min erreicht.

Typisch dabei ist, dass das Zielprofil der Oberfläche 16 mit einer Abweichung von kleiner +/-5nm eingestellt wird. Durch ein hocheffektives Rechenprogramm sowie Optimierung der definierten Strahlcharakteristik des Ionenstrahls kann die Genauigkeit der Ionenstrahlbearbeitung noch deutlich weiter gesteigert bzw. die Bearbeitungszeit noch weiter verringert werden.

Die Erfindung kann auf der Grundlage der Ansprüche in einer außerordentlich umfassenden Weise variiert werden. So ist es ohne weiteres möglich, den Ionenstrahl an die jeweilige Substratanordnung anzupassen, z.B. kann auch ein relativ breiter Ionenstrahl für Durchlaufanlagen zur Ionenstrahlbearbeitung zur Verfügung gestellt werden.

## Patentansprüche

1. Verfahren zur Ionenstrahlbearbeitung der Oberfläche eines Substrates, bei dem das Substrat gegenüber einem Ionenstrahl, der von einer Ionenstrahlquelle erzeugt wird, positioniert wird, und das bekannte Eigenschaftsmuster der Oberfläche des Substrates durch den Ionenstrahl partiell derart bearbeitet wird, dass ein neues technologisch definiertes Eigenschaftsmuster ausgebildet wird, **dadurch gekennzeichnet, dass**
- die Strahlcharakteristik des Ionenstrahles
- zur Erzeugung eines geometrischen Wirkungsmusters auf der Oberfläche (15) des Substrates (8)
- durch Veränderung der Ionenbeschleunigung, der Ionenenergieverteilung, der Ionenstromdichte, der Ionendichteverteilung,
- und/oder durch Pulsung des Ionenstrahles derart verändert wird,
- dass in Abhängigkeit des bekannten Eigenschaftsmusters
- und in Abhängigkeit des Verfahrensfortschrittes
- das neue technologisch definierten Eigenschaftsmuster eingestellt wird, wobei das aktuelle geometrische Wirkungsmuster des Ionenstrahls auf der Oberfläche (15) des Sustrates (8) vor und/oder während des Verfahrensablaufes mittels eines Ionensondenarrays (9), welches in der Ebene der zu bearbeitenden Oberfläche (15) des Substrates (8) angeordnet ist, gemessen wird.

2. Verfahren zur Ionenstrahlbearbeitung nach Anspruch 1, **dadurch gekennzeichnet, dass** das Substrat (8) und die Ionenstrahlquelle (1) zueinander rotieren und/oder gleichförmig oder ungleichförmig linear, kreisförmig oder in einer technologisch vorgegebenen Richtung bewegt werden.

3. Verfahren zur Ionenstrahlbearbeitung nach Anspruch 1 oder 2, **dadurch gekennzeichnet, dass** der Ionenstrahl aus mindestens zwei Einzel-Ionenstrahlen gebildet wird, deren Strahlcharakteristiken synchron oder unabhängig voneinander gesteuert und/oder zeitgleich oder zeitlich versetzt gepulst werden.

4. Verfahren zur Ionenstrahlbearbeitung nach einem der Ansprüche 1 bis 3, **dadurch gekennzeichnet, dass** der Winkel zwischen der Flächennormale der zu bearbeitenden Oberfläche des Substrates und der Achse des auf die Oberfläche auftreffenden Ionenstrahls verändert wird.

5. Vorrichtung zur Ionenstrahlbearbeitung der Oberfläche eines Substrates nach einem Verfahren der Ansprüche 2 bis 4, beinhaltend
- innerhalb einer Vakuumkammer einen Substratträger zur Halterung mindestens eines Substrates (8),
- der in einer Y-Achse (4) und einer X-Achse (6) bewegt werden kann und
- eine Ionenstrahlquelle (1); die in der Wand der Vakuumkammer derart gehaltert, ist,
- dass die Achse eines Ionenstrahls von der Ionenstrahlquelle (1),senkrecht zur zu bearbeitenden Oberfläche (15) des Substrates (8) in der Z-Achse (11) steht
- oder in einem zur Z-Achse geneigten Achse angeordnet werden kann,
- wobei der Abstand der Ionenstrahlquelle (1) von der zu bearbeitenden Oberfläche (15) des Substrates (8) fest oder veränderlich sein kann, und
- dass die Ionenstrahlquelle aus mindestens zwei einzelnen lonenstrahlquellen gebildet ist,
- deren einzelne Ionenstrahlen auf der Oberfläche des Substrates ein gemeinsames aktuelles geometrisches Wirkungsmuster des Ionenstrahls ausbilden,
und einem Ionensondenarray (9), welches in der Ebene der zu bearbeitenden Oberfläche (15) des Substrates (8), mit dem das aktuelle geometrische Wirkungsmuster des Ionenstrahls auf der Oberfläche (15) des Substrates (8) vor und/oder während des Verfahrensablaufes gemessen werden kann.

## Claims

1. Method for ion beam processing of the surface of a substrate, in the case of which the substrate is positioned opposite an ion beam which is produced by an ion beam source, and the known pattern of properties of the surface of the substrate is partially processed by the ion beam in such a way that a new technically defined pattern of properties is formed, **characterized in that**
- in order to produce a geometric activity pattern on the surface (15) of the substrate (8),
- by varying the ion acceleration, the ion energy distribution, the ion current density, the ion density distribution,
- and/or by pulsing the ion beam,
- the beam characteristic of the ion beam is varied in such a way
- that the new technically defined pattern of properties is set
- as a function of the known pattern of properties
- and as a function of the method progression, the current geometric activity pattern of the ion beam on the surface (15) of the substrate (8) being measured before and/or during the method sequence by means of an ion probe array (9) which is arranged **in that** plane of the surface (15) of the substrate (8) which is to be processed.

2. Method for ion beam processing according to Claim 1, **characterized in that** the substrate (8) and the ion beam source (1) rotate relative to one another, and/or are moved in a uniform or nonuniform fashion linearly, circularly or in a technically prescribed direction.

3. Method for ion beam processing according to Claim 1 or 2, **characterized in that** the ion beam is formed from at least two individual ion beams whose beam characteristics are controlled synchronously or independently of one another, and/or are pulsed simultaneously or with a temporal offset.

4. Method for ion beam processing according to one of Claims 1 to 3, **characterized in that** the angle between the surface normal of that surface of the substrate which is to be processed and the axis of the ion beam striking the surface is varied.

5. Device for ion beam processing of the surface of a substrate in accordance with a method of Claims 2 to 4, including
- inside a vacuum chamber a substrate holder for holding at least one substrate (8)
- which can be moved on a Y-axis (4) and an X-axis (6), and
- an ion beam source (1) which is held in the wall of the vacuum chamber in such a way that
- the axis of an ion beam from the ion beam source (1) is perpendicular along the Z-axis (11) to that surface (15) of the substrate (8) which is to be processed,
- or can be arranged along an axis inclined to the Z-axis,
- the distance of the ion beam source (1) from that surface (15) of the substrate (8) which is to be processed having the capacity to be fixed or variable, and
- that the ion beam source is formed from at least two individual ion beam sources
- whose individual ion beams form a common current geometric activity pattern of the ion beam on the surface of the substrate,
- and an ion probe array (9) which is arranged in that plane of the surface (15) of the substrate (8) which is to be processed and can be used to measure the current geometric activity pattern of the ion beam on the surface (15) of the substrate (8) before and/or during the method sequence.

## Revendications

1. Procédé de traitement de la surface d'un substrat par un faisceau d'ions, dans lequel le substrat est positionné par rapport à un faisceau d'ions formé par une source de faisceau d'ions et le motif connu de propriétés de la surface de substrat est traité partiellement par le faisceau d'ions de manière à former un nouveau motif de propriétés défini technologiquement,
**caractérisé en ce que**
- pour former un modèle géométrique d'action sur la surface (15) du substrat (8),
- la caractéristique d'émission du faisceau d'ions est modifiée
- par modification de l'accélération des ions, de la répartition d'énergie entre les ions, de la densité du courant ionique et de la répartition de la densité ionique
- et/ou par pulsation du faisceau d'ions,
- de manière à établir le nouveau profil de propriétés défini technologiquement
- en fonction du motif de propriétés connu et
- en fonction de l'avancement du procédé,
le motif géométrique d'action effective du faisceau d'ions sur la surface (15) substrat (8) étant mesuré avant et/ou pendant le déroulement du procédé au moyen d'une batterie (9) de sondes ioniques qui est disposée dans le plan de la surface (15) du substrat (8) qui doit être traitée.

2. Procédé de traitement par faisceau d'ions selon la revendication 1, **caractérisé en ce que** le substrat (8) et la source (1) de faisceau d'ions tournent l'un par rapport à l'autre et/ou sont déplacés de la même manière ou de manières différentes linéairement, circulairement ou dans une direction technologiquement prédéterminée.

3. Procédé de traitement par faisceau d'ions selon les revendications 1 ou 2, **caractérisé en ce que** le faisceau d'ions est formé d'au moins deux faisceaux d'ions distincts dont les caractéristiques sont commandées de manière synchronisée ou indépendamment l'une de l'autre et/ou qui sont pulsés simultanément ou avec un décalage temporel.

4. Procédé de traitement par faisceau d'ions selon l'une des revendications 1 à 3, **caractérisé en ce que** l'angle entre la normale à la surface du substrat qui doit être traitée et l'axe du faisceau d'ions incident sur la surface est modifié.

5. Dispositif de traitement par faisceau d'ions de la surface d'un substrat à l'aide d'un procédé selon les revendications 2 à 4, comprenant :
- à l'intérieur d'une chambre sous vide, un porte-substrat qui retient au moins un substrat (8)
- qui peut être déplacé suivant un axe Y (4) et un axe X (6) et
- une source (1) de faisceau d'ions qui est maintenue dans la paroi de la chambre sous vide de telle sorte que
- l'axe d'un faisceau d'ions provenant de la source (1) de faisceau d'ions est perpendiculaire à la surface (15) à traiter du substrat (8) dans la direction de l'axe Z (11)
- ou peut être disposé suivant un axe incliné par rapport à l'axe Z,
- la distance entre la source (1) du faisceau d'ions et la surface (15) à traiter du substrat (8) étant fixe ou pouvant être modifiée et
- la source de faisceau d'ions étant formée d'au moins deux sources distinctes de faisceau d'ions
- dont les différents faisceaux d'ions forment sur la surface du substrat un motif d'action géométrique effective commune des faisceaux d'ions,
- et une batterie (9) de sondes ioniques qui est disposée dans le plan de la surface (15) du substrat (8) qui doit être traitée et avec laquelle le motif géométrique d'action effective du faisceau d'ions sur la surface (15) du substrat (8) peut être mesuré avant et/ou pendant le déroulement du procédé.
